# EUROPEAN PATENT APPLICATION

(11) **EP 4 134 747 A1**
(43) Date of publication of application: **15.02.2023**
(21) Application number: 21191043.5
(22) Date of filing: 12.08.2021
(51) Int. Cl.: G03F 7/20

(54) **CONDITIONING APPARATUS AND METHOD**

(71) Applicant: ASML Netherlands B.V., 5500 AH Veldhoven (NL)
(72) Inventor: KLUGKIST, Joost, André, 5500 AH Veldhoven (NL)
(74) Representative: ASML Netherlands B.V.

(57) **Abstract**

A conditioning apparatus, said conditioning apparatus including at least one channel, wherein a conditioning fluid and a solid thermal conductor are disposed within the at least one channel. Also described is a system or sub-system including such a conditioning apparatus, and a lithographic apparatus including such a conditioning apparatus, system or sub-system. A method of conditioning a system or sub-system, said method including providing a conditioning fluid and a solid thermal conductor within a channel that is in thermal communication with the system or sub-system, and transferring thermal energy between the system or sub-system and the solid thermal conductor via the conditioning fluid is also provided. The use of such apparatuses or methods is also provided.

## Description

The present invention relates to a conditioning apparatus, a system or sub-system comprising such conditioning apparatus, a method of conditioning a system or sub-system, the use of such a conditioning apparatus, system, sub-system, or method in a lithographic apparatus or process, and a lithographic method utilising any of the aforesaid. The present invention has particular, but not exclusive, application in lithographic apparatuses and methods.

### BACKGROUND

A lithographic apparatus is a machine constructed to apply a desired pattern onto a substrate. A lithographic apparatus can be used, for example, in the manufacture of integrated circuits (ICs). A lithographic apparatus may for example project a pattern from a patterning device (e.g. a mask) onto a layer of radiation-sensitive material (resist) provided on a substrate.

The wavelength of radiation used by a lithographic apparatus to project a pattern onto a substrate determines the minimum size of features which can be formed on that substrate. A lithographic apparatus which uses EUV radiation, being electromagnetic radiation having a wavelength within the range 4-20 nm, may be used to form smaller features on a substrate than a conventional lithographic apparatus (which may for example use electromagnetic radiation with a wavelength of 193 nm).

Collecting EUV radiation into a beam, directing it onto a patterning device (e.g. a mask) and projecting the patterned beam onto a substrate is difficult because it is not possible to make a refractive optical element for EUV radiation. Therefore, these functions have to be performed using reflectors (i.e. mirrors). Even constructing a reflector for EUV radiation is difficult. The best available normal incidence reflector for EUV radiation is a multi-layer reflector (also known as a distributed Bragg reflector) which comprises a large number of layers which alternate between a relatively high refractive index layer and a relatively low refractive index layer. Each period, consisting of a high refractive index layer and a low refractive index layer, has a thickness equal to half the wavelength (λ/2) of the radiation to be reflected so that there is constructive interference between the radiation reflected at the high to low refractive index boundaries. Such a multilayer reflector still does not achieve a particularly high reflectivity and a substantial proportion of the incident radiation is absorbed by the multilayer reflector.

The absorbed radiation, including infra-red radiation also emitted by the radiation source, can cause the temperature of the multilayer reflector to rise. Known multilayer reflectors are formed on substrates made of materials having a very low coefficient of thermal expansivity, for example ULE^{™} or cordierite. In some cases, the cross-section of the beam when incident on a reflector may be small enough that localized heating of the reflector causes undesirable deformation of the surface figure of the reflector. Such deformation can cause imaging errors and the constant desire to image ever smaller features means that the amount of deformation that can be tolerated will only reduce. Unwanted heating of components is not limited to reflectors or mirrors, and there may be further elements, systems, or sub-systems within a lithographic apparatus which require cooling.

Existing reflectors in the projection systems of lithographic apparatuses, particularly EUV apparatuses, are cooled passively, i.e. by radiation, conduction, and convection. However, none of these modes of cooling allows a high rate of heat transfer. In particular, the reflectors are generally in a high vacuum or a low pressure of hydrogen so that heat transfer by convection is minimal. Active cooling of reflectors has been avoided because of the risk of introducing vibrations, which could easily be more problematic than the distortion caused by the localized heat rise.

The present invention has been devised to provide an improved or alternative conditioning system. The present invention has particular, but not exclusive, application as a conditioning system for a component of a lithographic apparatus. The following description makes reference to lithographic apparatuses, but it will be appreciated that the present invention may be used to condition other apparatuses.

### SUMMARY OF THE INVENTION

According to a first aspect of the present invention, there is provided a conditioning apparatus, said conditioning apparatus including at least one channel, wherein a conditioning fluid and a solid thermal conductor are disposed within the at least one channel.

In order to actively condition a component in need of conditioning, a conditioning fluid can be passed through channels within the component. The conditioning fluid is able to absorb thermal energy from the component to result in a heated conditioning fluid. The heated conditioning fluid is then passed away from the component, thereby removing thermal energy from the component and controlling the temperature of the component. The thermal energy is removed from the conditioning fluid at a location separate from the component being conditioned, and the cooled conditioning fluid is then able to be passed through the component being conditioned again. Whilst this is an efficient way to condition a component, there are some drawbacks. Perhaps the main issue with existing systems is that the flow of conditioning fluid can result in turbulence and vibrations within the component being conditioned. The turbulence and vibrations can be detrimental to the operation of certain apparatuses, such as lithographic apparatuses, particularly with regards to the operation of the elements which interact with the radiation beam used in lithographic apparatuses. Additionally, a conditioning fluid necessarily applies pressure to the channels of the component and this can result in deformation of optical surfaces, which may be located in a vacuum. It is necessary for the conditioning fluid to be pressurized in order to prevent cavitation of the conditioning fluid at the maximum temperature to which the conditioning fluid is exposed. This is known as print-through. Due to the extremely high precision of optical elements required by lithographic apparatuses, it is necessary for the conditioning fluid to be pressurized at a substantially stable pressure as even minor print-through variations caused by variation of the pressure in the conditioning channels of the said elements can be detrimental to the operation of the lithographic apparatus. The present invention may reduce print-through of the mentioned optical elements by reducing the maximum temperature of any local hot spots, thereby allowing a lowering of the pressure of the conditioning fluid.

The present invention provides a solid thermal conductor and a conditioning fluid disposed within a channel. The channel may be provided in the component itself or in a separate element in thermal communication with the component being conditioned. The solid thermal conductor is configured to conduct thermal energy away from the component being conditioned. The solid thermal conductor is able to transfer heat readily. As such, the solid thermal conductor may reduce any local hot-spots and allow the conditioning fluid to be provided at a lower pressure, thereby reducing the likelihood of print-through. The thermal conductivity of the solid thermal conductor is greater than that of the material comprising the component being conditioned. In the case of a mirror, the mirror may comprise ultra-low expansion glass or cordierite, which transfers heat slowly. The conditioning fluid provides a path for the transfer of thermal energy between a wall of the channel and the solid thermal conductor. Since the coefficient of thermal expansion of the component and the solid thermal conductor will be different, the conditioning fluid is able to accommodate any differential expansion of the two and thereby prevent aberrations introduced by the expansion of the solid causing aberrations by print-through, and to also prevent damage to either component whilst still providing a continuous path for thermal energy to pass. The solid thermal conductor is solid in the sense that it is not a fluid, but this does not necessarily require that it is a unitary block with no cavities. The solid thermal conductor may include one or more cavities or openings. The solid thermal conductor may be a heat pipe. As a heat pipe, the solid thermal conductor may comprise a tube having a fluid therein which is able to rapidly transfer thermal energy along the heat pipe. The solid thermal conductor may have a thermal conductivity of more than ten times, more than twenty times, more than fifty times, more than a hundred times, more than a thousand times, more than ten thousand times, more than one hundred thousand times, or more than a million times that of the material primarily comprising the component which is being conditioned. The thermal conductivity of the solid thermal conductor may be at least 175 W/m K greater than the thermal conductivity of the component which is being conditioned. In the case of optical elements, these may generally comprise ultra-low expansion glass or cordierite. The solid thermal conductor may only be partially disposed within the channel. In such cases, the solid thermal conductor extends outside of the channel. The solid thermal conductor may be comprised in a component which is being conditioned. For example, where the component being conditioned is a mirror, the solid thermal conductor may be provided within one or more of the conditioning channels that are comprised in the mirror. The conditioning apparatus according to the first aspect of the present invention may be separately formed from the component being conditioned, and may be put into thermal communication with the component being conditioned by any suitable means.

The apparatus may be configured such that, in normal use, the conditioning fluid is substantially static within the at least one channel. Whilst the conditioning fluid may move within the at least one channel during, for example, installation, cleaning, or maintenance, when the lithographic apparatus is operating, the conditioning fluid may be effectively static. In other words, there is no particular flow in a specific direction. Whilst there may be minor movement of the conditioning fluid due to the change in relative volume of the channel and the solid thermal conductor, when the apparatus has achieved a steady state, the conditioning fluid is preferably substantially or entirely stagnant in embodiments. One skilled in the art will appreciate that a variety of embodiments may be used with respect to the flow in the channels. For example, in some embodiments there may be some flow, the contribution of the flow to the removal of thermal energy is low or negligible. For example, the contribution of the flow to the removal of thermal energy may be less than 25%, less than 20%, less than 15%, less than 10%, less than 5%, less than 3%, or less than 1% of the entire amount of thermal energy being removed. This is possible due to the incorporation of the solid thermal conductor, which itself is able to transfer the majority of the thermal energy. In other embodiments, the contribution of flow to the removal of thermal energy may be high. For example, the contribution of the flow to the removal of thermal energy may be more than 50%. In these embodiments, flow induced vibrations will be suppressed to a lesser extent; the main purpose of the solid conductor is to enhance thermal diffusion to reduce the maximum temperature of local hot spots, thereby allowing lowering of the operating pressure of the conditioning fluid, reducing print-through effects. As such, the present invention can be used in different modes, with no flow, with a low degree of flow, or with a high degree of flow. The apparatus of the present invention provides advantages for each mode and it allows the operator to select such different modes. Without the apparatus of the present invention, the operator is restricted to a mode which necessarily relies on a flow of conditioning fluid.

The conditioning fluid may be a liquid. The conditioning fluid may be a gas. The conditioning fluid may be water. The conditioning fluid may be a gel. The conditioning fluid may include solid particles. The function of the conditioning fluid is to provide a path for the transfer of thermal energy between the component and the solid thermal conductor and to accommodate any difference in expansion between the two. The fluid may not necessarily be compressible. Where the fluid is incompressible or only slightly compressible, the apparatus may be configured to accommodate expansion of the conditioning fluid. As such, there may be provided a system for accommodating the thermal expansion such as an expansion chamber, a hydraulic accumulator, an expansion vessel, expansion joint, or expansion bellow, which avoids the pressure increasing within the channel and potentially resulting in print-through.

The solid thermal conductor may be formed from a ceramic. The ceramic may comprise silicon carbide, silicon nitride, silicon infiltrated silicon carbide, silicon infiltrated silicon nitride, diamond-infiltrated silicon carbide or diamond infiltrated silicon nitride. The solid thermal conductor may be formed from a metal. The metal may comprise aluminium. The solid thermal conductor may be formed from a metal-ceramic. The metal ceramic may be aluminium silicon carbide (AlSiC) or aluminium nitride (AlN). The solid thermal conductor may be selected from diamond or polycrystalline diamond. The solid thermal conductor may be a flexible material, optionally a flexible composite material. The flexible composite material may be polyethylene infiltrated with carbon nanotubes. The solid thermal conductor may be formed of combinations of any of the aforementioned materials. Each of these have high coefficients of thermal conductivity. As such, they are able to rapidly transfer thermal energy. They are each able to be formed into different shapes and so can be fitted to channels of various dimensions and shapes. The solid thermal conductor may be a heat pipe. A heat pipe is a tube including a fluid that is able to rapidly transfer thermal energy along the tube. The fluid may transition between a liquid and a gas to efficiently transfer thermal energy. The heat pipe may be a capillary heat pipe, a loop heat pipe, or an oscillating heat pipe.

The solid thermal conductor may be in thermal communication with a heat sink. The thermal communication may be direct or indirect. The indirect thermal communication may include a thermally conductive connection, which is optionally flexible. The heat sink may be passively or actively cooled. The function of the solid thermal conductor is to conduct thermal energy away from (or to) the component being conditioned, such as a component of a lithographic apparatus. In order for there to be a transfer of thermal energy, a temperature gradient is needed. In order to maintain such a temperature gradient, a heat sink may be provided in thermal communication with the solid thermal conductor.

The conditioning apparatus may be provided in thermal communication with an optical element of a lithographic apparatus. Whilst the apparatus could be used to condition other elements of a lithographic apparatus, the present invention has particular application to the conditioning of optical elements as distortions or vibrations in optical elements can negatively affect the performance of such optical elements.

The solid thermal conductor may be continuous. The solid thermal conductor may be discontinuous. Having a continuous thermal conductor will provide the most efficient path for thermal energy, it may not be possible for the thermal conductor to be provided as a unitary piece. Even so, since there is a conditioning fluid in thermal communication with the component being conditioned and the solid thermal conductor is in thermal communication with the conditioning fluid, it is still possible to transfer thermal energy between the component and the solid thermal conductor via the conditioning fluid.

A wall of the solid thermal conductor may be separated from at least one wall of the at least one channel by from around 0.05 mm to around 6 mm. The separation may be 5 mm or less, 4 mm or less, 3 mm or less, 2 mm or less, or 1 mm or less. The thickness of the layer of conditioning fluid between the wall of the channel and the solid thermal conductor need only be thick enough to accommodate differential expansion of the channel and the solid thermal conductor.

The solid thermal conductor may be in thermal communication with at least one other channel configured to receive a flow of conditioning fluid. Such a channel may serve as a heat sink. The flow of conditioning fluid may be configured to remove thermal energy from the solid thermal conductor to thereby allow the solid thermal conductor to continue to remove thermal energy from the component being conditioned. The flow of conditioning fluid may therefore be provided away from or remote from the component being conditioned and therefore vibrations caused by the flow of conditioning fluid are less likely to adversely affect operation of the lithographic apparatus.

According to a second aspect of the present invention, there is provided a system or sub-system comprising the conditioning apparatus according to the first aspect of the present invention. The system or sub-system may be a system or sub-system of a lithographic apparatus.

The system or sub-system may be an optical element. The optical element may be a mirror, a reticle, a sensor, or a fiducial. The system or sub-system may be a reticle stage clamp, a wafer stage, a reticle stage, a wafer stage clamp, or a frame to mount a component of a lithographic apparatus.

By providing a system or sub-system with the conditioning apparatus according to the first aspect of the present invention, the performance of such system or sub-system may be improved as print-through and vibrations are reduced.

According to a third aspect of the present invention, there is provided a lithographic apparatus comprising the conditioning apparatus according to the first aspect of the present invention or a system or sub-system according to the second aspect of the present invention.

Again, such a lithographic apparatus is less susceptible to print-through and vibrations induced by the flow of fluid therein.

According to a fourth aspect of the present invention, there is provided a method of conditioning a system or sub-system of a lithographic apparatus, said method including providing a conditioning fluid and a solid thermal conductor within a channel that is in thermal communication with the system or sub-system, and transferring thermal energy between the system or sub-system and the solid thermal conductor via the conditioning fluid.

The method provides for the conditioning of a system or sub-system of a lithographic apparatus that effects conditioning by transferring thermal energy to a solid thermal conductor via a conditioning fluid. This method avoids the need to provide a flow of conditioning fluid, which can result unwanted vibrations. The high thermal conductivity of the solid thermal conductor allows thermal energy to be removed efficiently and so localized hot spots are avoided and the maximum temperature to which the conditioning fluid is exposed is reduced, thereby allowing a lower pressure of conditioning fluid to be used, which in turn reduces print-through. Such a method provides for a wider range of operating modes. Due to the provision of the solid thermal conductor, it is possible to provide a method in which there is effectively no flow of conditioning fluid. This reduces or eliminates flow induced vibrations. A small flow of conditioning fluid may be used, with the flow being such that it is not the primary contributor to the removal of thermal energy. A high flow mode may be used, with the flow of conditioning fluid being the primary contributor (i.e. 50% of greater) to the removal of thermal energy. The high flow mode may not reduce flow induced vibrations as much as other modes, but allows the conditioning fluid to be provided at a lower pressure than would be the case where no solid thermal conductor is provided.

The method may include providing a heat sink in thermal communication with the solid thermal conductor. The heat sink may be in the form of a flow of conditioning fluid. The thermal communication may be provided by a flow of conditioning fluid. The thermal communication may be provided by another flexible solid thermal conductor. The thermal communication may be provided by another rigid solid thermal conductor.

According to a fifth aspect of the present invention, there is provided the use of a conditioning apparatus according to the first aspect of the present invention, a system or sub-system according to the second aspect of the present invention, a lithographic apparatus in accordance with the third aspect of the present invention, or a method according to the fourth aspect of the present invention in a lithographic apparatus or process.

According to a sixth aspect of the present invention, there is provided a lithographic method comprising projecting a patterned beam of radiation onto a substrate, wherein the patterned beam is directed or patterned using at least one optical element comprising a conditioning apparatus according to the first aspect of the present invention, a system or sub-system according to the second aspect of the present invention, or conditioned according to a method of the fourth aspect of the present invention.

It will be appreciated that features described in respect of one aspect or embodiment may be combined with any features described in respect of another aspect or embodiment and all such combinations are expressly considered and disclosed herein.

### BRIEF DESCRIPTION OF THE DRAWINGS

Embodiments of the invention will now be described, by way of example only, with reference to the accompanying schematic drawings in which corresponding reference symbols indicate corresponding parts, and in which:
Figure 1 depicts a lithographic apparatus according to an embodiment of the invention;
Figures 2a to 2c are schematic representations of different cooling modes, with Figure 2c depicting a cooling mode according to the present invention;
Figure 3 depicts a cross-section of a conditioning apparatus according to the present invention;
Figure 4a and 4b depict a side view and a top view of conditioning apparatuses according to the present invention;
Figure 5 depicts an embodiment of a conditioning apparatus according to the present invention; and
Figures 6 to 9 depict various embodiments of conditioning apparatuses according to the present invention; and;
Figure 10 depicts an embodiment of a conditioning apparatus according to the present invention including means for accommodating expansion of the conditioning fluid.

The features and advantages of the present invention will become more apparent from the detailed description set forth below when taken in conjunction with the drawings, in which like reference characters identify corresponding elements throughout. In the drawings, like reference numbers generally indicate identical, functionally similar, and/or structurally similar elements.

### DETAILED DESCRIPTION

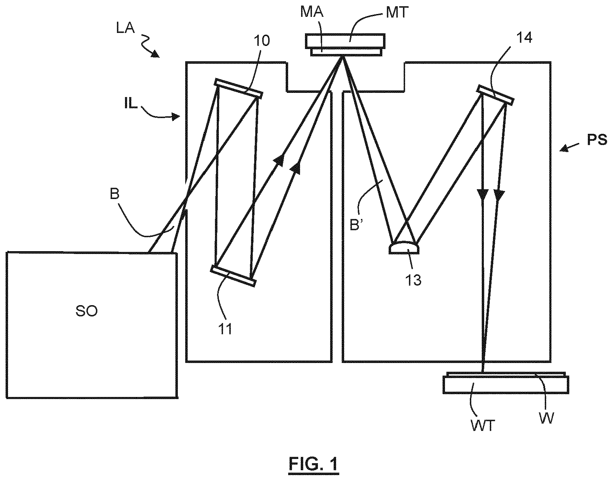

Figure 1 shows a lithographic system according to an embodiment of the present invention. The lithographic system comprises a radiation source SO and a lithographic apparatus LA. The radiation source SO is configured to generate an extreme ultraviolet (EUV) radiation beam B. The lithographic apparatus LA comprises an illumination system IL, a support structure MT configured to support a patterning device MA (e.g. a mask), a projection system PS and a substrate table WT configured to support a substrate W. The illumination system IL is configured to condition the radiation beam B before it is incident upon the patterning device MA. The projection system is configured to project the radiation beam B (now patterned by the mask MA) onto the substrate W. The substrate W may include previously formed patterns. Where this is the case, the lithographic apparatus aligns the patterned radiation beam B with a pattern previously formed on the substrate W.

The radiation source SO, illumination system IL, and projection system PS may all be constructed and arranged such that they can be isolated from the external environment. A gas at a pressure below atmospheric pressure (e.g. hydrogen) may be provided in the radiation source SO. A vacuum may be provided in illumination system IL and/or the projection system PS. A small amount of gas (e.g. hydrogen) at a pressure well below atmospheric pressure may be provided in the illumination system IL and/or the projection system PS.

The radiation source SO shown in Figure 1 is of a type which may be referred to as a laser produced plasma (LPP) source. A laser, which may for example be a CO₂ laser, is arranged to deposit energy via a laser beam into a fuel, such as tin (Sn) which is provided from a fuel emitter. Although tin is referred to in the following description, any suitable fuel may be used. The fuel may for example be in liquid form, and may for example be a metal or alloy. The fuel emitter may comprise a nozzle configured to direct tin, e.g. in the form of droplets, along a trajectory towards a plasma formation region. The laser beam is incident upon the tin at the plasma formation region. The deposition of laser energy into the tin creates a plasma at the plasma formation region. Radiation, including EUV radiation, is emitted from the plasma during de-excitation and recombination of ions of the plasma.

The EUV radiation is collected and focused by a near normal incidence radiation collector (sometimes referred to more generally as a normal incidence radiation collector). The collector may have a multilayer structure which is arranged to reflect EUV radiation (e.g. EUV radiation having a desired wavelength such as 13.5 nm). The collector may have an elliptical configuration, having two ellipse focal points. A first focal point may be at the plasma formation region, and a second focal point may be at an intermediate focus, as discussed below.

The laser may be separated from the radiation source SO. Where this is the case, the laser beam may be passed from the laser to the radiation source SO with the aid of a beam delivery system (not shown) comprising, for example, suitable directing mirrors and/or a beam expander, and/or other optics. The laser and the radiation source SO may together be considered to be a radiation system.

Radiation that is reflected by the collector forms a radiation beam B. The radiation beam B is focused at a point to form an image of the plasma formation region, which acts as a virtual radiation source for the illumination system IL. The point at which the radiation beam B is focused may be referred to as the intermediate focus. The radiation source SO is arranged such that the intermediate focus is located at or near to an opening in an enclosing structure of the radiation source.

The radiation beam B passes from the radiation source SO into the illumination system IL, which is configured to condition the radiation beam. The illumination system IL may include a facetted field mirror device 10 and a facetted pupil mirror device 11. The faceted field mirror device 10 and faceted pupil mirror device 11 together provide the radiation beam B with a desired cross-sectional shape and a desired angular distribution. The radiation beam B passes from the illumination system IL and is incident upon the patterning device MA held by the support structure MT. The patterning device MA reflects and patterns the radiation beam B. The illumination system IL may include other mirrors or devices in addition to or instead of the faceted field mirror device 10 and faceted pupil mirror device 11.

Following reflection from the patterning device MA the patterned radiation beam B enters the projection system PS. The projection system comprises a plurality of mirrors 13, 14 which are configured to project the radiation beam B onto a substrate W held by the substrate table WT. The projection system PS may apply a reduction factor to the radiation beam, forming an image with features that are smaller than corresponding features on the patterning device MA. A reduction factor of 4 may for example be applied. Although the projection system PS has two mirrors 13, 14 in Figure 1, the projection system may include any number of mirrors (e.g. six mirrors).

In use the optical elements of the lithographic apparatus, such as mirrors or reflectors, are heated by the radiation and it is therefore necessary to condition such optical elements. As such, a conditioning apparatus according to the present invention is integrated into the lithographic apparatus to provide the required conditioning. Conditioning usually requires the removal of thermal energy from the optical elements as they heat up in use and/or are subject to temperature variations.

The radiation sources SO shown in Figure 1 may include components which are not illustrated. For example, a spectral filter may be provided in the radiation source. The spectral filter may be substantially transmissive for EUV radiation but substantially blocking for other wavelengths of radiation such as infrared radiation.

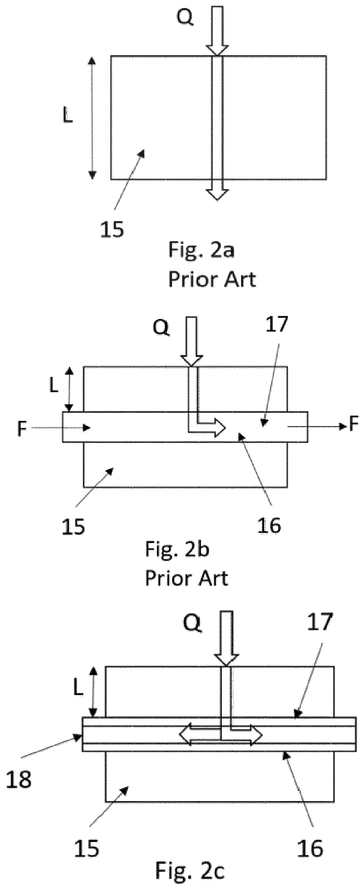

Figures 2a to 2c depict various cooling modes. Figure 2a depicts a cooling mode in which thermal energy Q passes through a mirror 15. The mirror 15 is generally formed from ultra-low expansion glass or cordierite which has a high thermal resistance. Due to the high thermal resistance, heat is transmitted very slowly and so the material heats up. The mirror 15 cools by several heat flows: radiative heat transfer, by convective heat transfer by the H₂ gas surrounding the mirror, and by conductive heat towards the cooler mirror side surfaces and the cooler bottom surface. The distance L between the front of the mirror and the bottom surface through which the heat has to be transferred is the full depth of the mirror 15. These heat flows are inefficient ways of cooling and so the temperature of the mirror 15 in use can be higher than desired. In this case, when switching illumination modes, the changed heat load distribution causes a greater than desired changed spatial thermal gradient between the optical surface and the outer surfaces of the mirror 15, causing aberrations introduced by the changed thermal expansion of the solid. Figure 2b depicts a cooling mode in which the mirror 15 is provided with a channel 16 through which a conditioning fluid 17, for example water, is flowed. The direction of flow is depicted by the arrows labelled F. Due to the presence of the channel 16, the distance L through which the heat has to be transferred is reduced as compared to Figure 2a. The conditioning fluid 17 is able to take the heat away from the mirror 15, thereby cooling the mirror 15. However, a flowing conditioning fluid 17 can cause flow induced vibrations. Figure 2c depicts an embodiment of a conditioning apparatus in accordance with the present invention in which a solid thermal conductor 18 is provided within the channel 16. The conditioning fluid 17 is provided between the wall of the channel 16 and the solid thermal conductor 18. The conditioning fluid 17 is substantially static, although is able to move to accommodate differences in thermal expansion of the walls of the channel 16 or mirror 15 and the solid thermal conductor 18. Since the solid thermal conductor 18 is configured to conduct thermal energy much more quickly than the material of the mirror 15, it is possible to remove thermal energy from the mirror 15 without the need for a flow of conditioning fluid 17. Since the conditioning fluid 17 is substantially static, it is possible to avoid flow induced vibrations. An expansion chamber, a hydraulic accumulator, an expansion vessel, an expansion joint, or an expansion bellow (not shown) may be provided at any suitable location to accommodate changes in volume of the conditioning fluid. Whilst the detailed description refers to a mirror, it will be appreciated that the present invention may equally be applied to a reticle stage clamp, a wafer stage, a reticle stage, a wafer stage clamp, or a frame to mount a component of a lithographic apparatus.

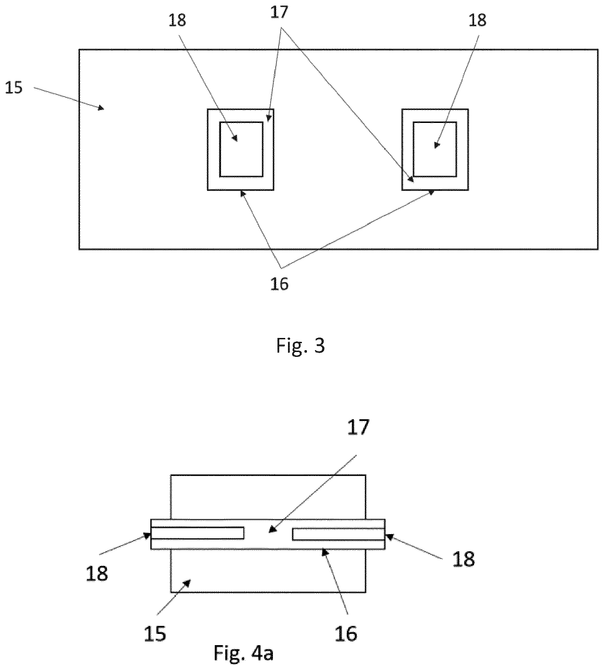

Figure 3 is a cross-sectional view of a conditioning apparatus according to an embodiment of the present invention. As shown, the solid thermal conductor 18 is disposed within a channel 16 within the mirror 15 and is surrounded by a layer of conditioning fluid 17. Although the cross-sectional shape of the channel 16 and the solid thermal conductor 18 is shown as square, the invention is not particularly limited to the cross-sectional shape of either of these features. Indeed the cross-sectional shape may be any shape. The solid thermal conductor 18 is shown as being a unitary piece, but it may include one or more cavities or openings. In addition, although the cross-sectional view shows the solid conductor 18 centered in the channel 16, the invention is not particularly limited to this positioning. It will be appreciated that the solid conductor 18 may have any positioning within the channel 16. The solid thermal conductor 18 does not necessarily need to be entirely surrounded by the conditioning fluid 17.

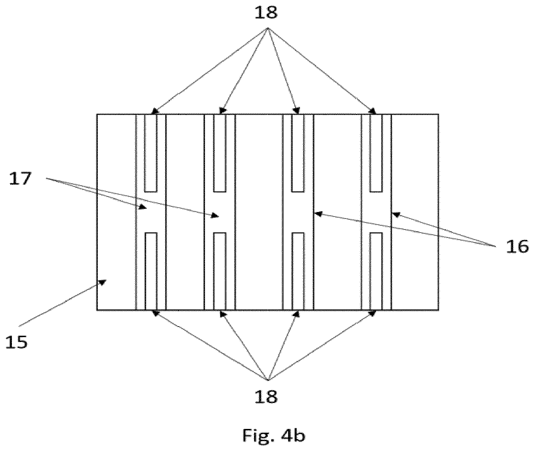

Figure 4a depicts an embodiment of a conditioning apparatus according to the present invention in which the solid thermal conductor 18 is not continuous. Even though the solid thermal conductor 18 may not be continuous, the conditioning fluid 17 is able to transfer thermal energy to or from the solid thermal conductor 18 to effect conditioning. Figure 4b depicts a plan view of an embodiment of a conditioning apparatus according to the present invention showing multiple channels 16 (not all labelled) including solid thermal conductors 18 and conditioning fluid 17.

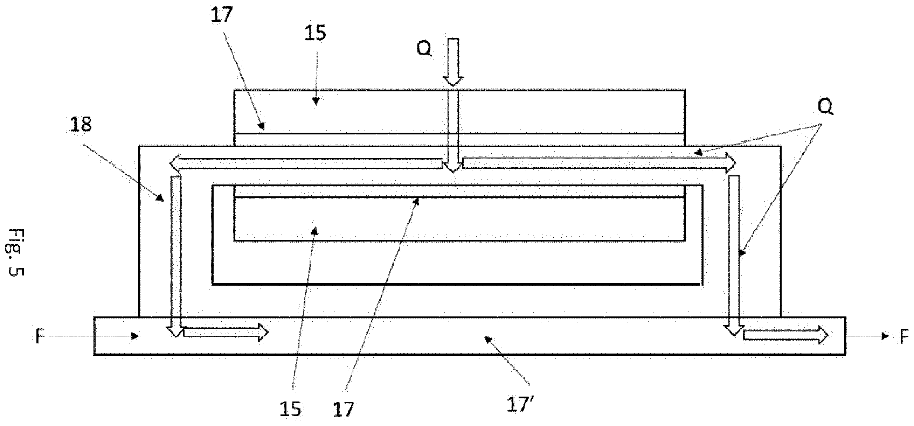

Figure 5 depicts an embodiment of a conditioning apparatus according to the present invention in which a flow F of a conditioning fluid 17', which may or may not be the same conditioning fluid as used to transfer thermal energy Q between the mirror 15 and the solid thermal conductor 18 and accommodate differential expansion thereof, is used to transfer thermal energy Q from the solid thermal conductor 18 and carried away. As shown, the thermal energy Q is transferred into the solid thermal conductor 18 via conditioning fluid 17. Due to the high thermal conductivity of the solid thermal conductor 18, the thermal energy Q is efficiently transferred along the solid thermal conductor 18. The solid thermal conductor 18 is in thermal communication with a heat sink. In the depicted example, the heat sink comprises a flow F of conditioning fluid 17' which is able to absorb thermal energy Q from the solid thermal conductor 18 and be carried away. The way in which the solid thermal conductor 18 is cooled is not particularly limiting and any suitable means may be used. The heat sink may also be in the form of an apparatus similar to the present invention comprising a solid thermal conductor, which may also be disposed in a channel housing a conditioning fluid.

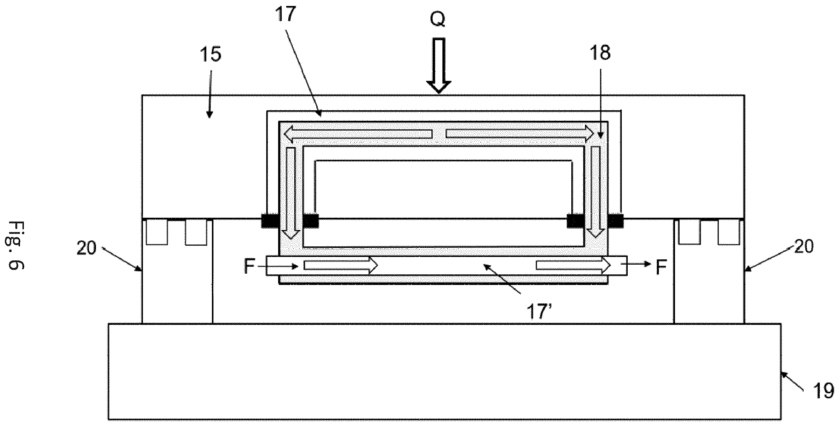

Figure 6 depicts an embodiment of a conditioning apparatus according to the present invention similar to that depicted in Figure 5, but further depicting a support frame 19 to which the mirror 15 is connected via connections 20.

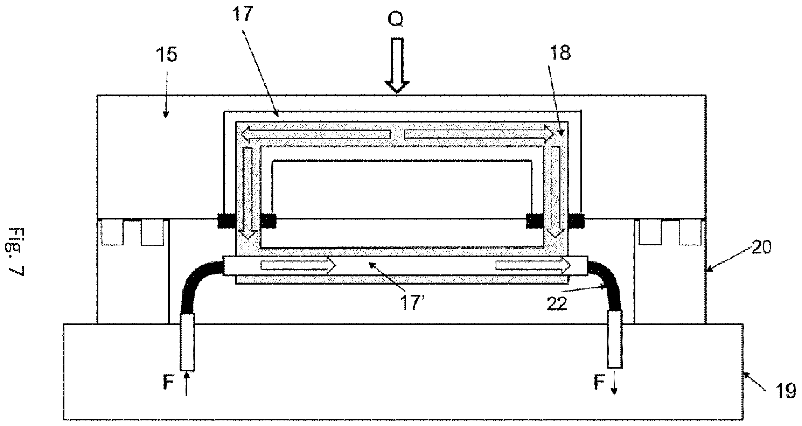

Figure 7 depicts a further embodiment of a conditioning apparatus according to the present invention similar to that depicted in Figures 5 and 6. In this embodiment, the flow of the secondary conditioning fluid 17' which is operable to cool the solid thermal conductor 18, is at least partially supported by the frame 19. The tube 22 supplying or receiving the flow may be flexible, have flexible elements, or may be non-flexible.

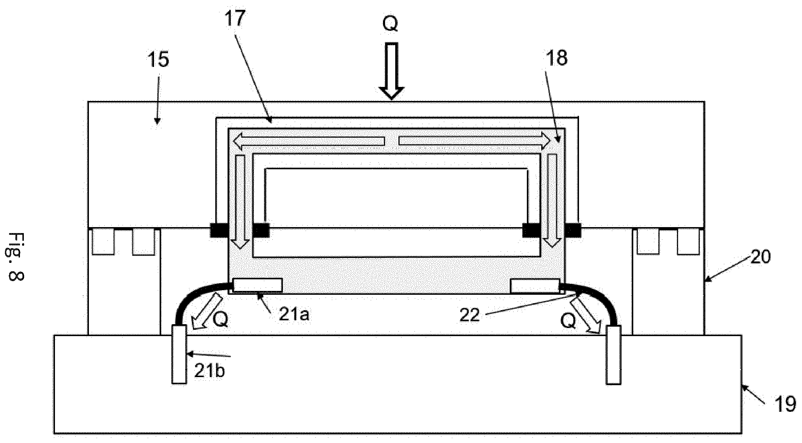

Figure 8 depicts a further embodiment of a conditioning apparatus according to the present invention similar to that depicted in Figures 5 to 7. In this embodiment, the secondary conditioning fluid 17', which is operable to cool the solid thermal conductor 18, is provided in one or more heat pipes 21, which include an evaporator portion 21a and a condenser portion 21b. The evaporator portion 21a and the condenser portion 21b may be connected by a connection tube 22, which may be flexible or may be non-flexible. The frame 19 may itself be cooled by any suitable means to remove thermal energy from the heat pipe 21. It will be appreciated that this figure is schematic and the relative orientation of portions of the heat pipe are shown for optimal understanding of the concepts behind the present invention.

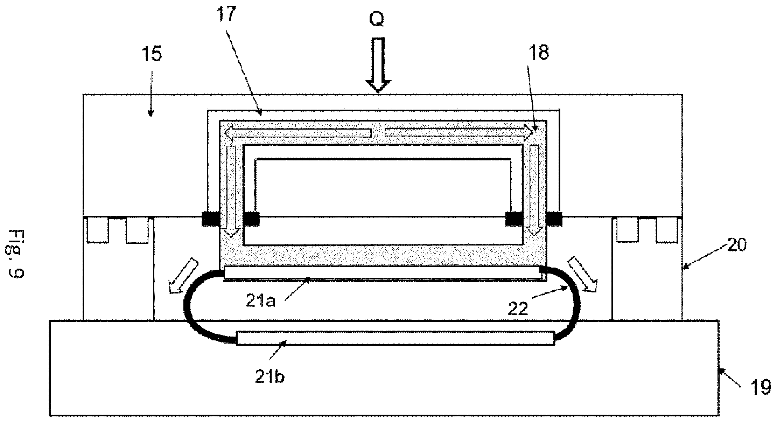

Figure 9 depicts a further embodiment of a conditioning apparatus according to the present invention similar to that depicted in Figures 5 to 8, particularly Figure 8. In this embodiment, the heat pipe 21 is in the form of a loop heat pipe 21. In embodiments, there may be separate heat pipes that are connected via thermal straps rather than via connection tube 22. Thermal straps are thermally conductive and are thereby able to transfer thermal energy between heat pipes. The thermal straps may be flexible or non-flexible. In embodiments, the solid thermal conductor 18 may be thermally connected to a heat sink via one or more thermal straps.

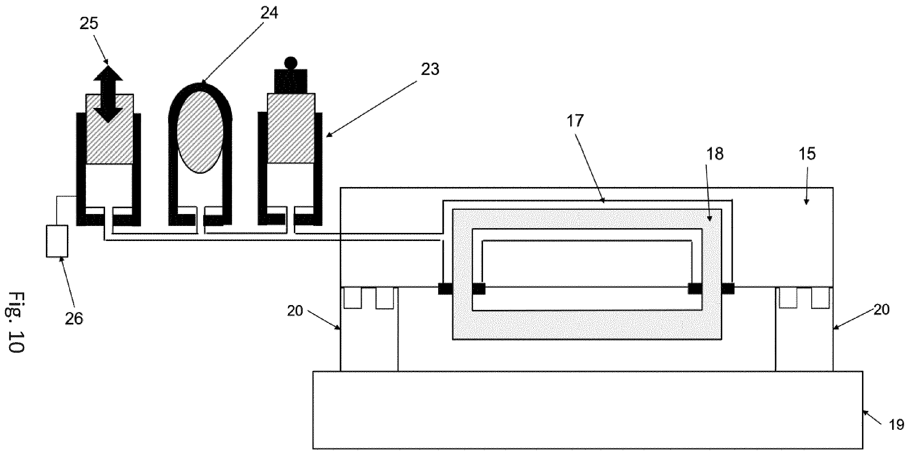

Figure 10 depicts an embodiment of the present invention in which an exemplary means for accommodating changes in volume of the conditioning fluid 17 is depicted. The change in volume of the conditioning fluid can be accommodated by any suitable means, such as an expansion chamber, a hydraulic accumulator, an expansion vessel, an expansion joint, or an expansion bellow. In the depicted exemplary embodiment, a number of different means of accommodating changes in volume of the conditioning fluid 17 are depicted. It will be appreciated that these may be provided individually or in any combination. As such, although the figure depicts three possibilities, this does not mean that all three are required. The means for accommodating changes in volume of the conditioning fluid may be any of the means described herein. The means for accommodating a change in volume may comprise one or more of a raised weight hydraulic accumulator 23, a bladder hydraulic accumulator 24, and an actuated piston 25. The raised weight hydraulic accumulator 23 functions by providing a piston within a bore that has a predetermined weight. An increase in pressure in the conditioning fluid 17 will move the piston within the bore until such a time as the pressure exerted by the conditioning fluid 17 will equal the force provided by the weight of the piston. The bladder hydraulic accumulator 24 includes a pressurized bladder which can be deformed by the pressure provided by the conditioning fluid 17. Again, as the pressure of the conditioning fluid 17 varies, the bladder will expand or contract to accommodate the change in pressure of the conditioning fluid. A third option is an actuated piston 25 arrangement, which is provided with a pressure sensor 26. When the conditioning fluid expands, the pressure increases. This increase in pressure is detected by the pressure sensor 26, which then controls an actuator that adjusts the position of the piston in order to accommodate the change in volume of the conditioning fluid and thereby control the pressure of the conditioning fluid 17.

In summary, the present invention provides for an apparatus which conditions an element of a lithographic apparatus, particularly an optical element such as a mirror, by transferring thermal energy away from such element via a solid thermal conductor provided within a channel that includes a conditioning fluid. The conditioning fluid is able to transfer the thermal energy and accommodate differential expansion of the components. The conditioning fluid is static, save for the minor movement associated with accommodating differential expansion of the solid thermal conductor and the component being conditioned, and so flow induced vibrations are eliminated. In addition, improved heat dissipation reduces the maximum temperature to which the conditioning fluid is exposed, which allows reduction of the operating pressure. This results in reduced print-through.. This improves the performance of the lithographic apparatus.

The present invention has particular, but not exclusive application, to the cooling of optical elements of lithographic apparatuses. The present invention also has particular, but not exclusive application, to the conditioning of systems or sub-systems of a lithographic apparatus, such as, for example a reticle stage clamp, a wafer stage, a reticle stage, a wafer stage clamp, or a frame to mount a component of a lithographic apparatus.

While specific embodiments of the invention have been described above, it will be appreciated that the invention may be practiced otherwise than as described.

The descriptions above are intended to be illustrative, not limiting. Thus it will be apparent to one skilled in the art that modifications may be made to the invention as described without departing from the scope of the claims set out below.

Other aspects of the invention are set out in the following numbered clauses.
1. A conditioning apparatus, said conditioning apparatus including at least one channel, wherein a conditioning fluid and a solid thermal conductor are disposed within the at least one channel.
2. The conditioning apparatus according to clause 1, wherein the apparatus is configured such that, in normal use, the conditioning fluid is substantially static within the at least one channel.
3. The conditioning apparatus according to clause 1 or clause 2, wherein the conditioning fluid is selected from a liquid and a gas, optionally where the conditioning fluid is water.
4. The conditioning apparatus according to any preceding clause, wherein the solid thermal conductor is selected from a ceramic, a metal, a ceramic-metal, or a flexible composite material, optionally wherein the material is selected from silicon carbide, silicon nitride, silicon infiltrated silicon carbide, silicon infiltrated silicon nitride, diamond infiltrated silicon carbide, diamond infiltrated silicon nitride, diamond, polycrystalline diamond, silicon nitride, aluminium, aluminium silicon carbide, aluminium nitride, polyethylene infiltrated with carbon nanotubes, or combinations thereof.
5. The conditioning apparatus according to any preceding clause, wherein the solid thermal conductor is in thermal communication with a heat sink.
6. The conditioning apparatus according to any preceding clause, wherein the conditioning apparatus is provided in thermal communication with an optical element of a lithographic apparatus.
7. The conditioning apparatus according to any preceding clause, wherein the solid thermal conductor is continuous, or wherein the solid thermal conductor is discontinuous.
8. The conditioning apparatus according to any preceding clause, wherein a wall of the solid thermal conductor is separated from a wall of the at least one channel by from around 0.05 mm to around 6 mm
9. The conditioning apparatus according to any preceding clause, wherein the solid thermal conductor is in thermal communication with i) at least one other channel configured to receive a flow of conditioning fluid, ii) a heat pipe, and/or iii) another solid thermal conductor, optionally wherein the another solid thermal conductor is flexible or rigid.
10. The conditioning apparatus according to any preceding clause, the apparatus being configured to accommodate expansion of the conditioning fluid, optionally wherein the apparatus includes an expansion chamber, a hydraulic accumulator, an expansion vessel, an expansion joint, or an expansion bellow.
11. A system or sub-system for a lithographic apparatus comprising the conditioning apparatus according to any of clauses 1 to 10.
12. The system or sub-system according to clause 11, wherein system or the sub-system is an optical element of a lithographic apparatus, optionally selected from the list consisting of: a mirror, a reticle, a sensor, or a fiducial.
13. The system or sub-system according to clause 11, wherein the system or sub-system is a reticle stage clamp, a wafer stage, a reticle stage, a wafer stage clamp, or a frame to mount a component of a lithographic apparatus.
14. A lithographic apparatus including the conditioning apparatus according to any of clause 1 to 10 or a system or sub-system according to any of clauses 11 to 13.
15. A method of conditioning a system or sub-system, said method including providing a conditioning fluid and a solid thermal conductor within a channel that is in thermal communication with the system or sub-system, and transferring thermal energy between the system or sub-system and the solid thermal conductor via the conditioning fluid.
16. The method according to clause 15, wherein the method further includes providing a heat sink in thermal communication with the solid thermal conductor.
17. The use of a conditioning apparatus according to any of clauses 1 to 10, a system or sub-system according to any of clauses 11 to 13, a lithographic apparatus in accordance with clause 14, or a method according to clause 15 or 16 in a lithographic apparatus or process.
18. A lithographic method comprising projecting a patterned beam of radiation onto a substrate, wherein the patterned beam is directed or patterned using at least one optical element comprising a conditioning apparatus according to any of clauses 1 to 10, a system or sub-system according to clauses 11 to 13, or conditioned according to a method of clause 15 or 16.

## Claims

1. A conditioning apparatus, said conditioning apparatus including at least one channel, wherein a conditioning fluid and a solid thermal conductor are disposed within the at least one channel.

2. The conditioning apparatus according to claim 1, wherein the apparatus is configured such that, in normal use, the conditioning fluid is substantially static within the at least one channel.

3. The conditioning apparatus according to claim 1 or claim 2, wherein the conditioning fluid is selected from a liquid and a gas, optionally where the conditioning fluid is water.

4. The conditioning apparatus according to any preceding claim, wherein the solid thermal conductor is selected from a ceramic, a metal, a ceramic-metal, or a flexible composite material, optionally wherein the material is selected from silicon carbide, silicon nitride, silicon infiltrated silicon carbide, silicon infiltrated silicon nitride, diamond infiltrated silicon carbide, diamond infiltrated silicon nitride, diamond, polycrystalline diamond, silicon nitride, aluminium, aluminium silicon carbide, aluminium nitride, polyethylene infiltrated with carbon nanotubes, or combinations thereof.

5. The conditioning apparatus according to any preceding claim, wherein the solid thermal conductor is in thermal communication with a heat sink.

6. The conditioning apparatus according to any preceding claim, wherein the conditioning apparatus is provided in thermal communication with an optical element of a lithographic apparatus.

7. The conditioning apparatus according to any preceding claim, wherein the solid thermal conductor is continuous, or wherein the solid thermal conductor is discontinuous.

8. The conditioning apparatus according to any preceding claim, wherein a wall of the solid thermal conductor is separated from a wall of the at least one channel by from around 0.05 mm to around 6 mm.

9. The conditioning apparatus according to any preceding claim, wherein the solid thermal conductor is in thermal communication with i) at least one other channel configured to receive a flow of conditioning fluid, ii) a heat pipe, and/or iii) another solid thermal conductor, optionally wherein the another solid thermal conductor is flexible or rigid.

10. The conditioning apparatus according to any preceding claim, the apparatus being configured to accommodate expansion of the conditioning fluid, optionally wherein the apparatus includes an expansion chamber, a hydraulic accumulator, an expansion vessel, an expansion joint, or an expansion bellow.

11. A system or sub-system for a lithographic apparatus comprising the conditioning apparatus according to any of claims 1 to 10.

12. The system or sub-system according to claim 11, wherein system or the sub-system is an optical element of a lithographic apparatus, optionally selected from the list consisting of: a mirror, a reticle, a sensor, or a fiducial.

13. The system or sub-system according to claim 11, wherein the system or sub-system is a reticle stage clamp, a wafer stage, a reticle stage, a wafer stage clamp, or a frame to mount a component of a lithographic apparatus.

14. A lithographic apparatus including the conditioning apparatus according to any of claim 1 to 10 or a system or sub-system according to any of claims 11 to 13.

15. A method of conditioning a system or sub-system, said method including providing a conditioning fluid and a solid thermal conductor within a channel that is in thermal communication with the system or sub-system, and transferring thermal energy between the system or sub-system and the solid thermal conductor via the conditioning fluid.
